(19) Europäisches Patentamt
European Patent Office
Office européen des brevets

(11) **EP 3 004 409 B1**

(12) **EUROPÄISCHE PATENTSCHRIFT**

(45) Veröffentlichungstag und Bekanntmachung des Hinweises auf die Patenterteilung:
**09.08.2017 Patentblatt 2017/32**

(51) Int Cl.:
***C22C 19/03*** (2006.01)  ***C22C 1/02*** (2006.01)
***C22F 1/10*** (2006.01)  ***H01L 39/24*** (2006.01)

(21) Anmeldenummer: **14754986.9**

(22) Anmeldetag: **06.06.2014**

(86) Internationale Anmeldenummer:
**PCT/DE2014/000283**

(87) Internationale Veröffentlichungsnummer:
**WO 2014/194881 (11.12.2014 Gazette 2014/50)**

(54) **VERFAHREN ZUR HERSTELLUNG EINER METALLFOLIE**

METHOD FOR PRODUCING A METAL FILM

PROCÉDÉ DE PRODUCTION D'UNE FEUILLE DE MÉTAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.06.2013 DE 102013009574**

(43) Veröffentlichungstag der Anmeldung:
**13.04.2016 Patentblatt 2016/15**

(73) Patentinhaber: **VDM Metals International GmbH 58791 Werdohl (DE)**

(72) Erfinder:
• **DE BOER, Nicole**
**58762 Altena (DE)**
• **GILGES, Stefan**
**58762 Altena (DE)**
• **APPEL, Karl-Heinz**
**58840 Plettenberg (DE)**
• **TAS, Zülfükil**
**53721 Siegburg (DE)**

(56) Entgegenhaltungen:
**WO-A2-2012/136181  DE-A1-102008 016 222**

• **SUBRAMANYA SARMA V ET AL: "Recrystallisation texture and magnetisation behaviour of some FCC Ni-W alloys", SCRIPTA MATERIALIA, ELSEVIER, AMSTERDAM, NL, Bd. 50, Nr. 7, 1. April 2004 (2004-04-01), Seiten 953-957, XP004488523, ISSN: 1359-6462, DOI: 10.1016/J.SCRIPTAMAT.2004.01.004**

**Beschreibung**

Die Erfindung betrifft ein Verfahren zur Herstellung einer Metallfolie aus einer Legierung, die mehr als 50 % Nickel aufweist, insbesondere ein Verfahren zur Herstellung einer Metallfolie, die an der Oberfläche im Wesentlichen aus Nickel und Wolfram besteht.

Sehr reine Nickellegierungen sind während der Warmumformung (z.B. Block-Brammenwalzung) anfällig hinsichtlich Materialfehlern, wie Rissen und Brüchen, insbesondere in dem Fall, wenn ein gegossener Block (z.B. VIM) noch umgeschmolzen (z.B. VAR) wird.

Für besondere Einsatzfälle, wie z.B. supraleitende Bänder werden sehr reine Legierungen benötigt, die als dünne Folien mit defektfreien Oberflächen die einen hohen Grand an Würfeltextur aufweisen. Dies ist mit üblichen großtechnischen Herstellungsverfahren bislang nicht zu vertretbaren Kosten zu fertigen. Die Aufgabe besteht darin, mit üblichen großtechnischen Herstellungsverfahren eine solche Folie zu vertretbaren Kosten zu fertigen. Dies ist bislang nicht möglich.

Die DE 697 06 083 T2 betrifft eine Eisen-Nickel-Legierung folgender chemischer Zusammensetzung (in Gew.-%)

$$30 \% \leq Ni + Co \leq 85 \%$$

$$0 \% \leq Co + Cu + Mn \leq 10 \%$$

$$0 \% \leq Mo + W + Cr \leq 4 \%$$

$$0 \% \leq V + Si \leq 2 \%$$

$$0 \% \leq Nb + Ta \leq 1 \%$$

$$0,003 \% \leq C \leq 0,05 \%$$

$$0,003 \% \leq Ti \leq 0,15 \%$$

$$0,003 \% \leq Ti + Zr + Hf \leq 0,15 \%$$

$$0,001 \% < S + Se + Te < 0,015 \%$$

$$Mg < 0,001 \%$$

$$Ca < 0,0025 \%$$

$$Al \leq 0,05 \%$$

$$0 < 0,0025 \%$$

$$N < 0,005 \%$$

$$P < 0,01 \%$$

$$Sc + Y + La + Ce + Fe + Nd + Sm < 0,01 \%,$$

wobei der Rest Eisen und aus der Verhüttung stammende Verunreinigungen sind, wobei die chemische Zusammensetzung außerdem die Beziehung: $0 \% \leq Nb + Ta + Ti + Al \leq 1 \%$ erfüllt.

Diese Druckschrift offenbart auch ein Verfahren zur Herstellung eines kaltgewalzten Bandes aus dieser Legierung, die eine kubische Textur aufweist, wobei ein warmgewalztes Band hergestellt wird, dieses Band mit einem Verformungsgrad von über 80 % kaltgewalzt wird, das Kaltband bei einer Temperatur, die höher ist als 550°C und niedriger als die Temperatur der sekundären Rekristallisation der Legierung, geglüht wird, um dieser eine kubische Textur zu verleihen.

Durch die DE 10 2008 016 222 A1 ist eine Metallfolie bekannt geworden, mit (in Gew.-%)

| Ni | 74 - 90 % |
| W | 10 - 26 % sowie |

Al und/oder Mg und/oder B in Gehalten

| Al | > 0 bis max. 0,02 % |
| Mg | > 0 bis max. 0,025 % |
| B | > 0 bis max. 0,005 %. |

Der Werkstoff ist schmelzmetallurgisch großtechnisch, mit mehr als 1t, herzustellen und kann bei geeigneter Behandlung eine Rekristallisations-Würfeltextur aufweisen. Hier wird zwar ein Verfahren zur schmelzmetallurgischen Herstellung erwähnt, eine weitere Prozessführung mit der die gewünschten Eigenschaften kostengünstig eingestellt werden können wird jedoch nicht offenbart.

Diese Metallfolie kann als Metallband für epitaktische Beschichtungen verwendet werden.

Die DE 2816173 offenbart ein Verfahren zur Fertigung von Ringbandkernen. Danach werden aufgewickelte Streifen einer Ni-Legierung einer Wärmebehandlung zwischen 900-1050°C unterzogen. Hierdurch kann eine Würfeltextur eingestellt werden. Das Verfahren wird auf NiFeMo-legierungen angewandt mit 63 bis 65,5 Gew% Nickel, 2 bis 4 Gew% Molybdän, Rest Eisen. Legierungen auf Basis von NiW werden hier nicht erwähnt.

Die DE102004060900 offenbart ein Halbzeug aus reinem Nickel oder aus einer Ni-Legierung mit einem Legierungselement der Gruppe Sc, Y, La, Ac welches durch Walzen und Wärmebehandeln in eine Würfeltextur überführt wird. Legierungen auf Basis von NiW werden hier explizit als ungeeignet für epitaktische Beschichtung bezeichnet. Ein konkretes Verfahren der Wärmebehandlung wird hier nicht offenbart.

DE 102005013368 offenbaren ein Verfahren zur Herstellung eines Halbzeug welche zur physikalisch-chemischen Beschichtung mit Supraleitenden Schichten eingesetzt werden kann. Hier wird kein Verfahren offenbart, welches einer großtechnischen Herstellung dient.

V. Subramanya et al / Scripta Materialia 50(2004) 953 - 957 offenbart folgenden Beitrag: Recrystallisation texture and magnetization behavior of some FCC Ni-W alloys. Hierbei wird auf Nickel-Wolfram-Legierungen hingewiesen, die im Labormaßstab in einem Iduktionsofen erschmolzen und in einer zylindrischen Form mit einem Durchmesser von 32 mm abgegossen wurden. Im Anschluss an eine Warmwalzung wurde das Vorprodukt kaltgewalzt, wobei ein Umformgrad > 95% vorgesehen wurde. Eine gute Rekristillisationswürfelltextur wurde erzielt Legierungen, die bis 5 Atom-% Wolfram enthielten.

Die WO 2012/136181 offenbart ein Verfahren zur Herstellung eines Substratbandes für Hochtemperatursupraleiter, indem ein nicht oder nur schwach ferromagnetisches metallisches Trägermaterial mit mindestens einer stark texturierten metallischen Deckschicht durch mechanisches Plattieren zu einem Metallbund verformt wird.

Der Erfindung liegt die Aufgabe zugrunde, ein neuartiges Verfahren zur Herstellung von Substratband für Hochtemperatur-Supraleiter bereitzustellen, mittels welchem Mengen > 1 Tonne wirtschaftlich verarbeitet werden können.

Diese Aufgabe wird gelöst durch ein Verfahren zur Herstellung einer Metallfolie aus einer Legierung, bestehend aus (in Gew.-%)

W 5 bis 30 %, wobei W bedarfsweise ganz oder teilweise durch Mo ersetzt werden kann,
Mg 0,0001 - 0,050 %, wobei Mg bedarfsweise ganz oder teilweise durch Ca ersetzt werden kann

| | |
|---|---|
| Ti | max. 0,10 % |
| Al | max.0,10 % |
| B | max. 0,020 % |
| Fe | max. 1,0 % |
| Co | max. 1,0 % |
| Mn | max. 0,20 % |
| Si | max. 0,20 % |
| Cr,Cu, Nb | jeweils max. 0,20 % |
| P | max. 0,020 % |
| C | max. 0,050 % |
| N | max.0,020 % |
| S | max. 0,020 % |
| Ni | Rest (> 50 %) |

sowie den üblichen erschmelzungsbedingten Verunreinigungen beinhaltend folgende Verfahrensschritte:

(a) die Legierung wird in Mengen von mehr als einer Tonne in einem Vakuuminduktionsofen, oder offen in einem Induktions- oder Lichtbogenofen, gefolgt von einer Behandlung in einer VOD oder VLF Anlage erschmolzen,

(b) anschließend wird die Legierung in Blöcken, Elektroden oder als Strangguss zur Bildung eines Vorprodukts abgegossen, ggf. gefolgt von einem ein- oder mehrmaligen Umschmelzen mittel VAR und/oder ESU

(c) danach wird das Vorprodukt bedarfsweise bei Temperaturen zwischen 800 und 1350°C für 1 h bis 300 h unter Luft oder Schutzgas geglüht,

(d) danach wird das Vorprodukt bei Temperaturen zwischen 1300°C und 600°C warmumgeformt, insbesondere warmgewalzt, wobei die Dicke des Eingangsmaterials um den Faktor 1,5 - 200 reduziert wird, so dass das Vorprodukt nach der Walzung eine Dicke von 1 bis 100 mm hat und nicht rekristallisiert und/oder erholt ist und/oder (dynamisch) rekristallisiert mit einer Korngröße kleiner 300 μm, insbesondere kleiner 150 μm, ist,

(e) das Vorprodukt wird anschließend gebeizt und oder geschliffen,

(f) danach wird das Vorprodukt zur Erzeugung einer Folie an eine Enddicke von 10 bis 300 μm, insbesondere von 40 bis 150 μm, mit einem Umformgrad größer 90 % kalt verformt, wobei die Kaltverformung mit Walzen mit definierter Oberfläche zur Einstellung von Rauigkeiten kleiner 2 μm erfolgt,

(g) die Folie wird im Anschluss an die Kaltumformung in Streifen von 5 bis 300 mm geschnitten,

(h) anschließend werden die Folienstreifen mit einem keramischen Pulver lose oder mittels eines Klebstoffs oder mittels eines in Alkohol aufgelösten Oxids beschichtet oder mit einer Trennfolie belegt und bedarfsweise getrocknet,

(i) die Folienstreifen werden danach ringförmig auf einen oder mehrere Dorne oder eine oder mehrere Hülsen aufgewickelt, wobei das innere und das äußere Ende jeweils mittels Punktschweißen oder Klammern befestigt wird,

(j) die ringförmig aufgewickelten Folienstreifen werden anschließend unter Schutzgas bei Temperaturen zwischen 600 und 1200°C für 1 min bis 300 h geglüht,

(k) wobei das geglühte folienartige Material nach dieser Glühung rekristallisiert ist und einen großen Anteil an Würfeltextur aufweist.

Vorteilhafte Weiterbildungen des erfindungsgemäßen Verfahrens sind den zugehörigen verfahrensgemäßen Unteransprüchen zu entnehmen.

Eine nach dem erfindungsgemäßen Verfahren hergestellte Metallfolie besteht vorteilhafterweise aus (in Gew.-%)

| | |
|---|---|
| W | 5 bis 30 % |
| Mg | 0,0001 bis 0,050 % |

Ni Rest sowie den üblichen erschmelzungsbedingten Verunreinigungen, wobei W bedarfsweise ganz oder teilweise durch Mo und Mg bedarfsweise ganz oder teilweise durch Ca ersetzt werden kann.

Vorteilhafte Weiterbildungen der Metallfolie sind den zugehörigen gegenständlichen Unteransprüchen zu entnehmen.

Die Metallfolie kann bedarfsweise noch folgende Elemente enthalten:

| | |
|---|---|
| Ti | max. 0,10 % |
| Al | max. 0,10 % |
| B | max. 0,020 % |
| Fe | max. 1,0 % |
| Co | max. 1,0 % |
| Mn | max. 0,20 % |
| Si | max. 0,20 % |
| Cr, Cu, Mg | jeweils max. 0,20 % |
| P | max. 0,020 % |
| C | max. 0,050 % |
| N | max. 0,020 % |
| S | max. 0,020 %. |

Darüber hinaus besteht die Möglichkeit, die nachstehenden Elemente wie folgt in der Legierung einzustellen:

| | |
|---|---|
| Mg | 0,0001 - 0,020%, |
| Ti | 0,001 bis 0,050 % |
| Al | 0,001 bis 0,050 % |
| B | max. 0,010 % |
| Fe | max. 1,0 % |
| Co | max. 1,0 % |
| Mn | max. 0,05 % |
| Si | max. 0,10 % |
| Cr, Cu, Nb, V, Ta | jeweils max. 0,10 % |
| P | max. 0,010 % |
| C | max. 0,030 % |
| N | max. 0,010 % |
| S | max. 0,010 % |
| O | max. 0,030 % |
| Ni | Rest. |

Von Vorteil ist, wenn die Legierung in Mengen von mehr als einer Tonne in einem Vakuuminduktionsofen oder offen in einem Induktions- oder Lichtbogenofen, gefolgt von einer Behandlung in einer VOD oder VLF Anlage erschmolzen wird, anschließend die Legierung in Blöcken, Elektroden oder als Strangguss zur Bildung eines Vorprodukts abgegossen wird, danach das Vorprodukt zusätzlich bei Temperaturen zwischen 800 und 1350°C für 1 h bis 300 h unter Luft oder Schutzgas geglüht wird, gefolgt von einem ein- oder mehrmaligem Umschmelzen mittel VAR und/oder ESU.

Ebenfalls vorteilhaft ist, wenn das Vorprodukt, das bei Temperaturen zwischen 1300 und 600°C warmgewalzt wird, wobei die Dicke des Eingangsmaterials um den Faktor 1,5 - 200 reduziert wird, so dass das Vorprodukt nach der Walzung eine Dicke von 1 bis 100 mm hat und nicht rekristallisiert und/oder erholt ist und/oder (dynamisch) rekristallisiert mit einer Korngröße kleiner 300 $\mu$m ist, danach zusätzlich ein 2. Mal und ggf. auch ein 3. Mal nach einer Glühung bei Temperaturen zwischen 800°C und 1350°C für 1 h bis 300h unter Luft oder Schutzgas bei Temperaturen zwischen 1300°C bis 600°C warmgewalzt wird, wobei die Dicke des Eingangsmaterial um den Faktor 1,5 bis 200 reduziert wird und nach der letzten Walzung eine Dicke von 1 bis 100 mm hat und nicht rekristallisiert ist oder/und erholt ist und/oder (dynamisch) rekristallisiert mit einer Korngröße kleiner 300 $\mu$m, insbesondere kleiner 150 $\mu$m, ist.

Darüber hinaus besteht die Möglichkeit, dass das Vorprodukt nach den (der) Warmwalzung(en) und dem anschließend Beizen geschliffen wird.

Des Weiteren kann nach dem Beizen und/oder Schleifen, die Erzeugung einer Folie der Enddicke von 10 bis 300 $\mu$m mit einem Umformgrad größer 90 % durch Kaltverformung mit Walzen mit definierter Oberfläche zur Einstellung von Rauigkeiten kleiner 2 $\mu$m erfolgen.

Einem weiteren Gedanken der Erfindung gemäß kann nach dem Beizen und/oder Schleifen, die Erzeugung einer Folie der Enddicke von 10 bis 300 $\mu$m mit einem Umformgrad größer 90 % durch Kaltverformung mit Zwischenglühungen bei Temperaturen zwischen 550°C und 1200°C und Glühzeiten für das Material zwischen 10s und 100 Stunden unter Luft oder reduzierendem Schutzgas erfolgen, wobei das Schutzgas aus Wasserstoff oder einen Wasserstoff/Stickstoffgemisch oder Argon oder einem Gemisch dieser Gase bestehen kann, gefolgt von einer Abkühlung im Ofen oder im ruhendem Schutzgas oder Luft, bewegtem (geblasenem) Schutzgas oder Luft, ggf. gefolgt von einem Beizvorgang, wobei das Material nach diesem Glühvorgang erholt ist oder/und eine Korngröße von kleiner 70$\mu$m hat.

Bevorzugt wird als keramisches Pulver ein oxidisches Pulver, insbesondere Magnesiumoxidpulver eingesetzt.

Alternativ besteht die Möglichkeit, dass als in einem Alkohol aufgelöstes Oxid Magnesiummethylat eingesetzt wird.

Des Weiteren besteht alternativ die Möglichkeit, dass der Kleber oder die Trennfolie, der/die sich auf den ringförmig auf einen oder mehrere Dorne oder eine oder mehrere Hülse(n) aufgewickelten Folienstreifen befindet, unter einem Sauerstoff enthaltenen Gas verbrannt wird, wobei das innere und das äußere Ende der Folienstreifen jeweils mittels Punktschweißen oder Verklammerung vor der Verbrennung befestigt worden ist.

Ebenfalls denkbar ist, wenn als Schutzgas für die Glühung der ringförmig aufgewickelten Folienstreifen Wasserstoff oder ein Wasserstoff/Stickstoffgemisch oder Argon oder einem Gemisch dieser Gasen eingesetzt wird.

Des Weiteren kann die Glühung unter Schutzgas mit mehreren Haltezeiten von 1 s bis 200 h bei verschiedenen Temperaturen zwischen 600°C und 1200°C erfolgen, wobei das spiralförmig gewickelte Band ggf. auf einen stabilisierenden Träger gelegt wird.

Weiterhin vorteilhaft ist, wenn nach der Glühung der ringförmig aufgewickelten Folienstreifen unter Schutzgas bei Temperaturen zwischen 600 und 1200°C die Schweißpunkte entfernt werden, die Folienstreifen danach ggf. auf eine Hülse gewickelt und die Schweißpunkte bzw. die Klammerung durch Klebestreifen ersetzt werden.

Von besonderem Vorteil ist, wenn die Warmumformung unterbrochen wird und anschließend ein Metallblechpaket durch Stapelung aus zwei oder mehreren dieser so gewalzten Produkte erzeugt wird, wobei das Blechpaket rundum verschweißt wird, danach das Blechpaket durch mechanisches Verformen wie beispielsweise Walzen warm verformt wird, wobei durch diese mechanische Verformung die Dicke des Pakets um den Faktor 1,5 bis 200 reduziert wird, mit ggf. einer oder mehreren Zwischenglühungen bei Temperaturen zwischen 800 und 1350°C für 1 h bis 300 h unter Luft oder Schutzgas, wobei ggf. die Legierungselemente der einzelnen Bleche durch eine oder mehrere Grenzflächen der Blechpakete in die Nachbarbleche diffundieren, danach das Paket an eine Enddicke von 10 bis 300 $\mu$m mit einem Umformgrad größer 90% kalt verformt wird, wobei mindestens eine der äußeren Paketschichten des Gesamtpaketes eine Textur aufweist.

Das verschweißte Blechpaket kann eine Länge zwischen 0,1 bis 20 m und eine Breite zwischen 0,1 und 5 m haben.

Alternativ ist auch denkbar, nach dem Warmumformen und Beizen und/oder nach einer Unterbrechung der Kaltumformung zwei oder mehrere Vorprodukte (warmumgeformt, kaltumgeformt oder ein Gemisch aus beiden) zu einem Paket gestapelt werden, wobei die Dicke der einzelnen Vorprodukte zwischen 100mm bis 0,08mm beträgt, die Vorprodukte ggf. vor dem Stapeln in Streifen von mindestens 10 mm geschnitten werden, die Vorprodukte ggf. entfettet werden, ggf. gefolgt von einer oder mehreren Behandlungen zur Erhöhung der Rauigkeit der Oberfläche der einzelnen Schichten wie beispielsweise Bürsten und/oder Schleifen, danach das Paket an eine Enddicke von 10 bis 300 $\mu$m mit einem Umformgrad größer 90% kalt verformt wird, wobei ggf. die Legierungselemente der einzelnen Bänder bei der (den) Glühung(en) durch eine oder mehrere Grenzflächen der Bandpakete in die Nachbarbänder diffundieren, wobei mindestens eine der äußeren Paketschichten des Gesamtpaketes eine Textur aufweist.

Des Weiteren kann bei der Erzeugung des Paketes durch Stapelung aus zwei oder mehreren warm- oder kaltumgeformten Produkten aus erfindungsgemäßen Legierungen eine oder mehrere dieser zum Paket gestapelten Schichten durch einen metallischen Werkstoff mit einer anderen Legierungszusammensetzung ersetzt werden, wobei mindestens eine der äußeren Schichten des Pakets weiterhin einer erfindungsgemäßen Legierung besteht.

Darüber hinaus kann hierbei eine oder mehrere dieser zum Paket gestapelten Schichten auch ersetzt werden durch eine Schicht aus einer Cu-Ni-Legierung mit ggf. weiteren Legierungselementen oder durch eine Schicht aus einer Ni-Cr-Legierung oder einer Ni-Cr-Fe-Legierung mit einem Ni-Gehalt von mindestens 5 % und ggf. weiteren Legierungselementen, wobei mindestens eine der äußeren Schichten des Paketes weiterhin aus einer erfindungsgemäßen Legierung besteht.

Darüber hinaus kann hierbei eine oder mehrere dieser zum Paket gestapelten Schichten auch ersetzt werden durch eine Schicht aus einer Cu-Ni-Legierung mit 0 bis 12 % anderen Legierungselementen oder durch eine Schicht aus einer Ni-Cr-Legierung oder einer Ni-Cr-Fe-Legierung mit einem Ni-Gehalt von mindestens 5 % und 0 bis 12 % weiteren Legierungselementen, wobei mindestens eine der äußeren Schichten des Paketes weiterhin aus einer erfindungsgemäßen Legierung besteht.

Darüber hinaus kann hierbei eine oder mehrere dieser zum Paket gestapelten Schichten auch ersetzt werden durch eine Oxidschicht, oder durch eine Nitridschicht, oder durch eine Klebeschicht, wobei mindestens eine der äußeren Schichten des Pakets weiterhin aus einer erfindungsgemäßen Legierung besteht.

Vorteilhaft ist hierbei, wenn an der texturierten Oberfläche die mittlere Korngröße gleich oder kleiner der doppelten Dicke der Deckschicht ist.

Die so hergestellte Metallfolie wird zur Beschichtung mit hochtemperatursupraleitenden Schichten, insbesondere Oxiden ggf. mit einer oder mehreren Pufferschichten verwendet.

Das erfindungsgemäße Verfahren zur Herstellung von Metallfolien wird durch die folgenden Beispiele erläutert:

Für die Herstellung von Metallfolien wurde eine Legierung großtechnisch in einer Menge von 17 Tonnen im Vakuuminduktionsofen hergestellt und anschließend in Blöcken abgegossen.

In Tabelle 1 ist die Analyse (in Gew.%) einer erfindungsgemäßen großtechnisch erzeugten Legierung dargestellt, welche als Block abgegossen wurde.

## Tabelle 1

| Legierung | Chemische Zusammensetzung (Gewichts-%) | | | | | | | | | | | | | | | | | | |
|---|---|---|---|---|---|---|---|---|---|---|---|---|---|---|---|---|---|---|---|
| | Ni | Co | Cu | Mo | W | Cr | Nb | Si | C | S | Mg | Ca | Al | Ti | Fe | Mn | O | N | B | P |
| 1 | 85,6 | 0,01 | <0,01 | <0,01 | 14,30 | <0,01 | <0,001 | 0,02 | 0,004 | <0,002 | 0,003 | <0,001 | <0,005 | <0,01 | 0,05 | <0,01 | 0,003 | <0,002 | <0,001 | 0,002 |

Der Block wurde anschließend bei Temperaturen zwischen 600°C und 1250°C zu einem Vorprodukt warmgewalzt mit einer End-Dicke des Vorproduktes zwischen 2 und 10 mm und einer mittleren Korngröße von 5 bis 50 μm, wobei dabei die Dicke des Materials um den Faktor 50 bis 200 reduziert wurde. Anschließend wurde das Vorprodukt gebeizt und danach mit einem Umformgrad von mehr als 90% an 0,08 mm Dicke kalt gewalzt, wobei das Kaltwalzen an einer Zwischenabmessung zwischen 0,5 und 5 mm Dicke unterbrochen wurde und zusätzlich eine Glühung an dem Zwischenprodukt bei einer Temperatur zwischen 600°C und 1200°C und mit einer Glühdauer von 10 Sekunden bis 100 Minuten durchgeführt wurde. Anschließend besitzt die Folie eine mittlere Korngröße kleiner als 70 μm. Die so erzeugte 0,08 mm dicke Folie wurde anschließend in Streifen geschnitten mit unterschiedlichen Streifenbreiten von 10 bis 200 mm.

Die 10 mm bis 200 mm breiten Metallfolienstreifen wurden mit einem MgO-Pulver beschichtet. Die so beschichteten Streifen wurden anschließend auf eine Hülse aufgewickelt und das innere und äußere Ende wurde mittels Klammern befestigt. Anschließend wurden die so aufgewickelten Streifen bei Temperaturen zwischen 600°C und 1190°C und einer Glühdauer zwischen 30 Minuten und 100 h unter Wasserstoff geglüht, wobei mit einer Aufheizrate zwischen 1°C pro Minute bis 2000°C pro Minute im Temperaturbereich zwischen 600°C und 1190°C aufgeheizt wurde, und wobei mit einer Abkühlrate zwischen 2000°C pro Minute und 0,1°C pro Minute aus dem Temperaturgebiet zwischen 600°C und 1190°C abgekühlt wurde.

Anschließend wurden die Streifen von den Hülsen gelöst und abgerollt und danach wurden die Folienoberflächen gereinigt und anschließend mittels dem bekannten Verfahren EBSD (Electron Backscattering Diffraction) darauf hin untersucht, wieviel % der untersuchten Folienstreifenoberflächen eine Würfeltextur aufweisen (Würfeltexturgrad), bei der die Würfelkörner aus der idealen Würfellage nicht mehr als 10° fehlorientiert sind, wobei idealerweise bedeutet, dass diese Körner mit Würfeltextur exakt parallel zur Folienoberfläche liegen, d.h. nicht aus der Ebene heraus verkippt sind, und dass die Körner in der Ebene nicht gegeneinander verdreht sind. In Tabelle 2 sind Ergebnisse aus diesen EBSD-Messungen beispielhaft aufgeführt. Die Proben wurden darüber hinaus noch metallografisch untersucht: die Proben sind rekristallisiert und besitzen eine mittlere Korngröße zwischen 10 und 60 μm.

Tabelle 2

| Geglühte Proben aus Legierung 1 | Metallfoliendicke | Würfeltexturgrad (10°) |
|---|---|---|
| 1 | 0,08 mm | 82% |
| 2 | 0,08 mm | 86% |
| 3 | 0,08 mm | 91% |
| 4 | 0,08 mm | 88% |

(fortgesetzt)

| Geglühte Proben aus Legierung 1 | Metallfoliendicke | Würfeltexturgrad (10°) |
|---|---|---|
| 5 | 0,08 mm | 98% |
| 6 | 0,08 mm | 71% |

Für die Herstellung von Metallfolien wurde darüber hinaus eine weitere Legierung großtechnisch in einer Menge von 18 Tonnen im Vakuuminduktionsofen hergestellt und anschließend in Elektroden abgegossen. Aus einer Elektrode wurde durch Umschmelzen mittels VAR ein Block erzeugt.

In Tabelle 3 ist die Analyse (in Gew.%) .%), welche an drei unterschiedlichen Stellen im Block bestimmt wurde, dieser erfindungsgemäßen großtechnisch erzeugten Legierung dargestellt.

## Tabelle 3

| Proben Legierung 2 | Chemische Zusammensetzung (Gewichts-%) | | | | | | | | | | | | | | | | | | | |
|---|---|---|---|---|---|---|---|---|---|---|---|---|---|---|---|---|---|---|---|---|
| | Ni | Co | Cu | Mo | W | Cr | Nb | Si | C | S | Mg | Ca | Al | Ti | Fe | Mn | O | N | B | P |
| 1 | 85,8 | 0,01 | <0,01 | <0,01 | 14,1 | <0,01 | 0,001 | 0,02 | 0,002 | <0,0005 | 0,002 | 0,001 | <0,005 | <0,01 | 0,02 | <0,01 | 0,001 | <0,001 | <0,001 | 0,002 |
| 2 | 85,3 | 0,01 | <0,01 | <0,01 | 14,6 | <0,01 | 0,005 | 0,02 | 0,002 | <0,0005 | 0,003 | 0,001 | <0,005 | <0,01 | 0,02 | <0,01 | 0,001 | <0,001 | <0,001 | 0,002 |
| 3 | 85,8 | 0,01 | <0,01 | <0,01 | 14,1 | <0,01 | 0,001 | 0,02 | 0,002 | <0,0005 | 0,002 | 0,001 | <0,005 | <0,01 | 0,02 | <0,01 | 0,001 | <0,001 | <0,001 | 0,002 |

Der so erzeugte umgeschmolzene Block wurde anschließend bei Temperaturen zwischen 600°C und 1250°C warmgewalzt an eine Dicke zwischen 2 und 10 mm, wobei dabei die Dicke des Materials um den Faktor 50 bis 200 reduziert wurde. Es wurden Proben an diesem Vorprodukt entnommen und es wurde eine mittlere Korngröße des Vorproduktes zwischen 5 bis 60 μm ermittelt. Anschließend wurde das Vorprodukt gebeizt und danach mit einem Umformgrad von mehr als 90% an 0,06 mm Dicke kalt gewalzt. Diese Walzung wurde zur Abnahme einer Teilmenge eines Vorproduktes unterbrochen an einer Zwischenabmessung zwischen 0,5 und 5 mm Dicke und anschließend wurde diese Teilmenge zusätzlich einer Glühung unter Schutzgas unterzogen bei einer Temperatur zwischen 700°C und 1200°C mit einer Glühdauer zwischen 10 Sekunden bis 100 Minuten und anschließend weiter an 0,06 mm kalt gewalzt. Die so erzeugten 0,06 mm dicken Folien (mit bzw. ohne Zwischenglühung) wurden anschließend in Streifen geschnitten mit unterschiedlichen Streifenbreiten von 10 mm bis 200 mm. Danach wurde beispielhaft eine Teilmenge der zwischen 10 mm und 200 mm breiten Folienstreifen aus dieser Folien-Herstellung mit einem MgO-Pulver mittels Klebstoff beschichtet und anschließend getrocknet. Diese Streifen wurden anschließend auf mehrere Hülsen aufgewickelt und das innere und äußere Ende wurde mittels Punktschweißen fixiert. Es wurde weiterhin eine Teilmenge der zwischen 10 mm und 200 mm breiten Folienstreifen nach dem Kaltwalzen und Streifenschneiden mit einem MgO-Pulver beschichtet und danach auf Hülsen aufgewickelt und auch hier wurde das innere und äußere Ende mittels Punktschweißen fixiert. Es wurde weiterhin eine Teilmenge der zwischen 10 mm und 200 mm breiten Folienstreifen nach dem Kaltwalzen und Streifenschneiden ohne eine Beschichtung auf Hülsen aufgewickelt und auch hier wurde das innere und äußere Ende mittels Punktschweißen fixiert.

Anschließend wurden die so aufgewickelten Folienstreifen bei Temperaturen zwischen 600°C und 1190°C mindestens 15 Minuten und maximal 72 Stunden unter Schutzgas geglüht, wobei Stickstoff bis zu Temperaturen von 700/800°C verwendet und ab 700/800°C Stickstoff durch Wasserstoff ersetzt wurde. Eine Teilmenge der Folienstreifen wurde in einem Argon/5%Wasserstoff-Gemisch geglüht. Die Glühungen wurden so durchgeführt, dass die Folienstreifen mit einer Aufheizrate zwischen 1°C pro Minute bis 2000°C pro Minute im Temperaturbereich zwischen 600°C und 1190°C aufgeheizt, und mit einer Abkühlrate zwischen 2000°C pro Minute und 0,1°C pro Minute aus dem Temperaturgebiet zwischen 600°C und 1190°C abgekühlt wurde.

Anschließend wurden zur Ermittlung der Folienstreifen-Eigenschaften die Folienstreifen von den Hülsen gelöst und abgerollt und die Folienoberflächen gereinigt. Der Volumenbruchteil der Würfeltextur der so geglühten Folienstreifen wurde mittels Röntgendiffrakometer-Messungen mit Hilfe der bekannten Methode der Ermittlung der Orientierungsverteilung der Kristallite (Orientierungsverteilungsfunktion "OVF" oder "ODF") ermittelt, wobei hierbei eine Abweichung von maximal 5 ° um die ideale Ausrichtung der Würfelkörner verwendet wurde, um das Volumen der Würfeltextur (Würfeltexturgrad) zu berechnen.

Die Ergebnisse sind in Tabelle 4 zusammengefasst. Außerdem wurden die Proben metallografisch untersucht mit dem Ergebnis, dass die Proben rekristallisiert waren und es wurde eine mittlere Korngröße der geglühten Folienstreifen ermittelt und Ergebnisse zwischen 20 und 40 μm ermittelt.

Tabelle 4

| Beschichtung | Glühung | Legierung 2 mit Zwischenglühung beim Kaltwalzen | Legierung 2 ohne Zwischenglühung beim Kaltwalzen |
|---|---|---|---|
| | | Würfeltexturgrad (5°) | Würfeltexturgrad (5°) |
| ohne Beschichtung | 1 | keine Messung möglich, da die Folien verklebt waren | |
| MgO-Pulver mittels Klebstoff | 2 | 65 | 65 |
| MgO-Pulver | 3 | 62,4 | - |
| | 4 | 70,8 | 68 |
| | 5 | 71,4 | - |
| | 6 | 62,8 | 75 |
| | 7 | 72,2 | 69 |
| | 8 | 76,6 | 65 |
| | 9 | 60,4 | 63 |
| | 10 | - | 72 |
| | 11 | 72,4 | 67 |
| | 12 | 79,2 | 74 |
| | 13 | 66 | 60 |
| | 14 | - | 82 |
| | 15 | - | 54 |

Beispielhaft wurde eine Teilmenge an 10 mm bis 200 mm breiten Folienstreifen wie oben beschrieben in Wasserstoff geglüht und eine weitere Teilmenge in einem Argon/5%Wasserstoff-Gemisch geglüht und die Folien wurden nach dem Ablösen, Abrollen und Reinigen anschließend mittels dem bekannten Verfahren EBSD (Electron Backscattering Diffraction) darauf hin untersucht, wieviel % der untersuchten Folienstreifenfläche eine Würfeltextur aufweisen (Würfeltexturgrad), bei der die Würfelkörner aus der idealen Würfellage nicht mehr als 10° fehlorientiert sind.

In Tabelle 5 sind Ergebnisse aus diesen EBSD-Messungen beispielhaft aufgeführt.

Tabelle 5

| Probe aus Legierung 2 | Glühung | Glühatmosphäre | Würfeltexturgrad (10°) |
|---|---|---|---|
| 1 | 1 | Wasserstoff | 97% |
| 2 | 2 | Wasserstoff | 96% |
| 3 | 3 | Wasserstoff | 97% |
| 4 | 4 | Argon/5%Wasserstoff | 99,7% |
| 5 | 5 | Argon/5%Wasserstoff | 99% |
| 6 | 6 | Argon/5%Wasserstoff | 99,9% |

Diese Beispiele, die in Tabelle 1 bis 4 zusammengefasst sind, zeigen, dass Metallfolien großtechnisch nach dem beschriebenen Verfahren hergestellt werden können und anschließend nach dem beschriebenen Verfahren geglüht werden konnten, so dass die Metallfolienstreifen rekristallisiert sind und einen großen Anteil Würfeltextur aufweisen.

Darüber hinaus wurde die Herstellung der Metallfolie aus Legierung 2 nach der wie oben beschriebenen Warmwalzung sowie der wie oben beschriebenen Kaltwalzung unterbrochen bei einer Dicke des Vorproduktes zwischen 1 mm und 0,05 mm und es wurde eine Teilmenge entnommen und diese mit polierten Walzen an End-Dicke 0,06 mm kalt gewalzt. Danach wurde die Rauigkeit der Oberfläche der 0,06 mm dicken Folie untersucht und es wurden Werte kleiner 1 μm detektiert. Der Würfeltexturanteil wurde durch diese Walzung mit polierten Walzen nicht verringert.

Die so hergestellten und geglühten rekristallisierten Metallfolien aus Legierung 1 und aus Legierung 2 wurden mit einer oder mehreren Puffer-Schichten und der hochtemperatursupraleitenden Schicht YBCO beschichtet. An diesen beschichteten Produkten konnte mittels induktiver Messung ein kritischer Strom von mindestens 50 A bei 77K gemessen werden. Diese Beispiele zeigen somit, dass mit diesem Verfahren Metallfolien hergestellt werden konnten, die sich für die Beschichtung mit Puffer und Supraleiterschichten eignen und damit ein supraleitendes Produkt erzeugt werden konnte.

Darüber hinaus wurde die Herstellung der Metallfolien aus Legierung 2 nach der wie oben beschriebenen Warmwalzung sowie der wie oben beschriebenen Kaltwalzung an einer Produktdicke zwischen 1mm und 0,1 mm unterbrochen und eine Teilmenge dieses Zwischenproduktes wurde entnommen zur Erzeugung eines Paketstapels, wobei dieses entnommene Zwischenprodukt aus Legierung 2 als Deckschicht auf genau ein anderes warmumgeformtes Produkt einer anderen Legierung (Trägerschicht) aufgebracht wurde. Als Trägerschicht wurden drei verschiedene Legierungen (Legierung 3, Legierung 4, Legierung 5) verwendet, deren Analysen in Tabelle 6 dargestellt sind.

Tabelle 6

| Legierung | Element | | | | | | | | | | |
|---|---|---|---|---|---|---|---|---|---|---|---|
| | C | S | Cr | Ni | Mn | Si | Ti | Cu | Fe | P | Al |
| Legierung 3 | 0,04 | 0,003 | 16,4 | Rest | 0,2 | 0,4 | 0,2 | 0,01 | 9,37 | 0,008 | 0,14 |
| Legierung 4 | 0,05 | 0,002 | 22,9 | Rest | 0,7 | 0,2 | 0,4 | 0,02 | 14,58 | 0,008 | 1,35 |
| Legierung 5 | 0,04 | 0,003 | 19,6 | Rest | 0,4 | 1,3 | <0,1 | <0,01 | 0,18 | 0,002 | 0,12 |

Diese Trägerschichten aus Legierung 3 bis 5 wurden mittels Schmelzen, Gießen in Blöcke und Warmumformen im Temperaturbereich zwischen 600°C und 1300°C an eine Dicke zwischen 4,5 mm bis 5,5 mm hergestellt. Anschließend wurden die Oberflächen der verwendeten Trägerfolien und auch die Oberflächen der verwendeten Deckschichtfolien aus Legierung 2 geschliffen, und mittels Bürsten aufgeraut und entfettet. Vor der Stapelung wurden die Vorprodukte in 10 mm bis 200 mm breite Metallfolienstreifen geschnitten. Danach wurde daraus das Paket durch Stapelung gebildet wie in Tabelle 7 (Deckschicht Werkstoff und Trägerschicht Werkstoff) dargestellt ist.

Das jeweilige Paket wurde an eine End-Dicke zwischen 10 μm und 300 μm kalt verformt, wobei zunächst an eine Zwischendicke zwischen 1,5 bis 2,5 mm kalt gewalzt und anschließend eine Glühung des Zwischenproduktes im Temperaturgebiet zwischen 600°C und 1300°C für eine Glühdauer von 1 bis 90 Minuten unter Argon durchgeführt wurde. Diese Wärmebehandlung dient der Interdiffusion zwischen den beiden ursprünglichen Schichten, wodurch eine feste Verbindung zwischen der ursprünglichen Deckschicht und der ursprünglichen Trägerschicht entsteht. Anschließend wurde das Zwischenprodukt an eine End-Dicke zwischen 70 und 300 μm kalt gewalzt, wobei das Paket mit einem Umformgrad von mehr 90% verformt wurde. Danach wurden die 10 mm bis 200 mm breiten Metallfolienstreifen auf eine Hülse aufgewickelt und das innere und äußere Ende wurde mittels Klammern fixiert. Anschließend wurden die so aufgewickelten Streifen bei Temperaturen zwischen 600°C und 1150°C und einer Glühdauer zwischen 30 Minuten und 100 h unter einem Argon/Wasserstoff-Gemisch geglüht, wobei mit einer Aufheizrate zwischen 1°C pro Minute bis 2000°C pro Minute im Temperaturbereich zwischen 600°C und 1190°C aufgeheizt wurde, und wobei mit einer Abkühlrate zwischen 2000°C pro Minute und mit 0,1°C pro Minute aus dem Temperaturgebiet zwischen 600°C und 1190°C abgekühlt wurde. Die Streifen wurden anschließend gelöst und abgerollt und untersucht wie folgt: An den jeweiligen erzeugten Endprodukten wurden mittels metallografischen Schliffen die mittlere Korngröße der Deckschicht, die Verbindung der Schichten (Deckschicht und Trägerschicht) untereinander untersucht und es wurde mittels dem bekannten Verfahren EBSD der Würfeltexturgrad der Deckschicht (bis 10° Misorientierung aus der idealen Würfellage) ermittelt. Die metallografischen Untersuchungen zeigen, dass nach der Kaltverformung an Enddicke alle untersuchten Produkte eine gute Verbindung untereinander ohne Ablösung der Einzelschichten aufweisen und dass die Deckschicht rekristallisiert ist.

In Tabelle 7 sind beispielhaft Ergebnisse der Untersuchungen dargestellt.

Tabelle 7

| Deckschicht Werkstoff | Trägerschicht Werkstoff | Dicke der Trägerschicht (Vor Paketbildung) | Dicke Plattierter Verbund (Zwischenprodukt) | Dicke nach Kaltwalzen (Endprodukt) | Dicke der Deckschicht aus Legierung 2 (Endprodukt) | Mittlerer Korndurchmesser der Deckschicht aus Legierung 2 (Endprodukt) | Würfeltexturgrad (10°) (Deckschicht Endprodukt)) |
|---|---|---|---|---|---|---|---|
| Legierung 2 | Legierung 3 | 4,9 mm | 1,6 mm | 75 $\mu$m | 8 $\mu$m | 19 $\mu$m | 20-42% |
| Legierung 2 | Legierung 3 | 4,9 mm | 1,6 mm | 124 $\mu$m | 11 $\mu$m | 19 $\mu$m | 72-81% |
| Legierung 2 | Legierung 4 | 4,9 mm | 2,0 mm | 123 $\mu$m | 11 $\mu$m | 18 $\mu$m | 75-81% |
| Legierung 2 | Legierung 5 | 5,1 mm | 2,1 mm | 129 $\mu$m | 11 $\mu$m | 18 $\mu$m | 91-92% |

Für das Paket aus Legierung 2/Legierung 5 mit einer Deckschicht-Dicke von 11 μm wurde nach der Glühung ein hoher Würfeltexturgrad von mindestens 91 % erreicht. Eine sehr dünne Deckschicht (Endprodukt) aus dem Paket aus Legierung 2/Legierung 3 von 8 μm ergibt mit dem Verfahren eine nur geringe Würfeltextur von bis zu 42%. Damit zeigte sich, dass bei zu geringer Schichtdicke des Deckmaterials nicht mehr die ausgeprägte Würfeltextur eingestellt werden konnte. Nur bei Proben, bei denen die Schichtdicke der Deck-Schicht deutlich über der Hälfte der mittleren Korngröße lag, konnte mit dem erfindungsgemäßem Verfahren ein hinreichend großer Anteil an Würfeltextur der Deckschicht zur Beschichtung mit supraleitenden Schichten hergestellt werden.

Diese Beispiele, die in den Tabellen 6 und 7 zusammengefasst sind, zeigen, dass Metallfolien großtechnisch nach dem beschriebenen Verfahren hergestellt werden können und anschließend nach dem beschriebenen Verfahren geglüht werden konnten, so dass die Metallfolienstreifen rekristallisiert sind und einen großen Anteil Würfeltextur aufweisen.

Die vorangehenden Beispiele zeigen, dass sich mit dem beschriebenen Verfahren die Herstellung von Metallfolien großtechnisch darstellen lässt. Aus Kostengründen wurden darüber hinaus zusätzlich beispielhaft zur Untersuchung des Legierungseinflusses weitere Legierungen in geringen Mengen von weniger als 50 kg in einem Labor-Vakuumofen hergestellt und in Blöcken abgegossen. Zusätze von Elementen verschlechtern die Texturschärfe. Sie tun dies, indem sie beispielsweise an der Oberfläche der Metallfolie Oxide auf den Korngrenzen oder im Korn bilden, welche das geordnete Aufwachsverhalten auf der Folien-Textur mit Oxiden und Supraleitern behindern. Die Menge der für diesen Mechanismus zur Verfügung stehenden Elemente blieb daher auch in diesen Legierungen im Labormaßstab stark reduziert.

In Tabelle 8 sind die Analysen (in Gew.%) dieser erzeugten Legierungsprodukte dargestellt.

Tabelle 8

| Element | LB1 | LB2 | LB3 | LB4 | LB5 | LB6 | LB7 | LB8 | LB9 |
|---|---|---|---|---|---|---|---|---|---|
| C | 0,0006 | 0,0008 | 0,0016 | 0,0012 | <0,002 | 0,005 | 0,002 | 0,002 | 0,002 |
| S | <0,002 | <0,002 | <0,002 | <0,002 | 0,0005 | 0,0005 | 0,001 | 0,002 | <0,001 |
| N | <0,001 | <0,001 | <0,001 | <0,001 | 0,001 | 0,001 | 0,001 | 0,001 | 0,001 |
| Cr | <0,01 | <0,01 | <0,01 | <0,01 | 0,01 | 0,01 | 0,01 | 0,01 | 0,01 |
| Ni | Rest | Rest | Rest | Rest | Rest | Rest | Rest | Rest | Rest |
| W | 20,0 | 24,4 | 20,3 | 24,1 | 14,3 | 14,5 | 13,4 | 13,6 | 13,7 |
| Mn | <0,01 | <0,01 | <0,01 | <0,01 | 0,01 | 0,01 | 0,01 | 0,01 | 0,01 |
| Si | 0,02 | 0,02 | 0,02 | 0,02 | 0,02 | 0,02 | 0,02 | 0,02 | 0,02 |
| Mo | <0,01 | <0,01 | <0,01 | <0,01 | 0,01 | 0,01 | 0,01 | 0,01 | 0,01 |
| Co | <0,01 | <0,01 | 0,01 | 0,01 | 0,01 | 0,01 | 0,01 | 0,01 | 0,01 |
| Ti | <0,01 | <0,01 | <0,01 | <0,01 | 0,01 | 0,01 | 0,01 | 0,01 | 0,04 |
| Nb | <0,001 | <0,001 | <0,001 | <0,001 | <0,001 | <0,001 | <0,001 | <0,001 | <0,001 |
| Ca | <0,001 | <0,001 | <0,001 | <0,001 | <0,001 | <0,001 | <0,001 | <0,001 | <0,001 |
| Cu | <0,01 | <0,01 | <0,01 | <0,01 | 0,01 | 0,01 | 0,01 | 0,01 | 0,01 |
| Fe | 0,01 | 0,01 | 0,01 | 0,01 | 0,01 | 0,01 | 0,01 | 0,01 | 0,01 |
| P | <0,002 | <0,002 | 0,002 | 0,005 | 0,002 | 0,002 | 0,002 | 0,002 | 0,002 |
| Al | <0,005 | <0,005 | 0,005 | <0,005 | 0,005 | 0,005 | 0,005 | 0,005 | 0,005 |
| Mg | 0,008 | 0,004 | 0,005 | 0,005 | 0,0002 | 0.010 | 0,002 | 0,0002 | 0,0002 |
| B | <0,001 | <0,001 | <0,001 | 0,001 | 0,001 | 0,001 | 0,001 | 0,001 | 0,001 |
| O | 0,007 | 0,011 | 0,01 | 0,013 | 0,009 | 0,002 | 0,016 | 0,004 | 0,01 |

Die so erzeugten Blöcke wurden anschließend bei Temperaturen zwischen 800°C und 1200°C unter Luft geglüht. Danach wurden die geglühten Blöcke bei einer Temperatur zwischen 600°C und 1250°C warm gewalzt an eine Dicke zwischen 2 und 8 mm, wobei dabei die Dicke des Eingangsblockes um den Faktor 8 bis 12 reduziert wurde.

Die so durch Warmwalzen erzeugten Vorprodukte wurden anschließend gebeizt und geschliffen und danach mit einem Umformgrad von mehr als 90 % an 0,08 mm Dicke kalt gewalzt, wobei das Kaltwalzen an einer Zwischenabmessung zwischen 5 mm und 0,07 mm Dicke unterbrochen wurde und es wurde zusätzlich eine oder mehrere Glühungen an den Zwischenprodukten bei einer Temperatur zwischen 600°C und 1200°C und mit einer Glühdauer von 10 Sekunden bis 100 Minuten teilweise unter Stickstoff (Temperatur geringer als 700/800°C) und teilweise unter Wasserstoff (Temperatur größer 700/800°C) durchgeführt. Danach besitzen die Folien eine mittlere Korngröße kleiner als 70 $\mu$m. Die so erzeugte 0,08 mm dicke Folie wurde danach in Streifen geschnitten mit unterschiedlichen Streifenbreiten von 10 bis 50 mm.

Die 10 mm bis 50 mm breiten Metallfolienstreifen wurden mit einem MgO-Pulver beschichtet. Die so beschichteten Streifen wurden anschließend auf eine Hülse aufgewickelt und das innere und äußere Ende wurde mittels Klammern fixiert. Anschließend wurden die so aufgewickelten Streifen bei Temperaturen zwischen 600°C und 1190°C und einer Glühdauer zwischen 30 Minuten und 100 h unter einem Argon/5%Wasserstoff-Gemisch geglüht, wobei mit einer Aufheizrate zwischen 1°C pro Minute bis 2000°C pro Minute im Temperaturbereich zwischen 600°C und 1190°C aufgeheizt und mit einer Abkühlrate zwischen 2000°C pro Minute und mit 0,1°C pro Minute aus dem Temperaturgebiet zwischen 600°C und 1190°C abgekühlt wurde.

Anschließend wurden die Streifenoberflächen gereinigt und danach mit dem bekannten Verfahren EBSD (Electron Backscattering Diffraction) darauf hin untersucht, wieviel % der untersuchten Folienstreifenfläche eine Würfeltextur aufweist, bei der die Würfelkörner aus der idealen Würfellage nicht mehr als 10° aus ihrer idealen Lage fehlorientiert sind.

In Tabelle 9 sind Ergebnisse aus diesen EBSD-Messungen und aus Messungen der mittleren Korngröße der Folienproben beispielhaft aufgeführt.

Tabelle 9

| Legierung | Dicke der Folie | Glühung | mittlere Korngröße der Folie | % Würfeltextur Missorientierung max. 10° von idealer Würfellage |
|---|---|---|---|---|
| LB1 | 0,08mm | 1 | 15$\mu$m | 88,7 |
| LB1 | 0,08mm | 2 | 16$\mu$m | 89,1 |
| LB1 | 0,08mm | 3 | 18$\mu$m | 78,6 |
| LB2 | 0,08mm | 1 | 20$\mu$m | 64,5 |
| LB2 | 0,08mm | 2 | 18$\mu$m | 54,2 |
| LB2 | 0,08mm | 3 | 17$\mu$m | 63,8 |
| LB3 | 0,08mm | 1 | 27$\mu$m | 96,6 |
| LB4 | 0,08mm | 1 | 25$\mu$m | 91,4 |
| LB5 | 0,08mm | 4 | 17$\mu$m | 81,2 |
| LB6 | 0,08mm | 4 | 18$\mu$m | 90,3 |
| LB7 | 0,08mm | 4 | 17$\mu$m | 89,3 |
| LB8 | 0,08mm | 4 | 20$\mu$m | 85,8 |
| LB9 | 0,08mm | 4 | 19$\mu$m | 86,5 |

Die Beispiele in Tabelle 7, 8 und 9 zeigen, dass auch bei einer Variation der Analyse mit erhöhtem W-Gehalt eine Metallfolie mit dem Verfahren herstellbar ist, die rekristallisiert ist und einen hohen Anteil an Würfeltextur nach der Glühung besitzt.

**Patentansprüche**

1.  Verfahren zur Herstellung einer Metallfolie aus einer Legierung, bestehend aus (in Gew.-%)

| | |
|---|---|
| W | 5 bis 30 %, wobei W bedarfsweise ganz oder teilweise durch Mo ersetzt werden kann, |
| Mg | 0,0001 - 0,050 %, wobei Mg bedarfsweise ganz oder teilweise durch Ca ersetzt werden kann |
| Ti | max. 0,10 % |
| Al | max.0,10 % |

(fortgesetzt)

| B | max. 0,020 % |
|---|---|
| Fe | max. 1,0 % |
| Co | max. 1,0 % |
| Mn | max. 0,20 % |
| Si | max. 0,20 % |
| Cr, Cu, Nb | jeweils max. 0,20 % |
| P | max. 0,020 % |
| C | max. 0,050 % |
| N | max.0,020 % |
| S | max. 0,020 % |
| Ni | Rest (> 50 %) |

sowie den üblichen erschmelzungsbedingten Verunreinigungen beinhaltend folgende Verfahrensschritte:

(a) die Legierung wird in Mengen von mehr als einer Tonne in einem Vakuuminduktionsofen, oder offen in einem Induktions- oder Lichtbogenofen, gefolgt von einer Behandlung in einer VOD oder VLF Anlage erschmolzen,

(b) anschließend wird die Legierung in Blöcken, Elektroden oder als Strangguss zur Bildung eines Vorprodukts abgegossen, ggf. gefolgt von einem ein- oder mehrmaligen Umschmelzen mittel VAR und/oder ESU

(c) danach wird das Vorprodukt bedarfsweise bei Temperaturen zwischen 800 und 1350°C für 1 h bis 300 h unter Luft oder Schutzgas geglüht,

(d) danach wird das Vorprodukt bei Temperaturen zwischen 1300°C und 600°C warmumgeformt, insbesondere warmgewalzt, wobei die Dicke des Eingangsmaterials um den Faktor 1,5 - 200 reduziert wird, so dass das Vorprodukt nach der Walzung eine Dicke von 1 bis 100 mm hat und nicht rekristallisiert und/oder erholt ist und/oder (dynamisch) rekristallisiert mit einer Korngröße kleiner 300 $\mu$m, insbesondere kleiner 150 $\mu$m, ist,

(e) das Vorprodukt wird anschließend gebeizt und oder geschliffen,

(f) danach wird das Vorprodukt zur Erzeugung einer Folie an eine Enddicke von 10 bis 300 $\mu$m, insbesondere von 40 bis 150 $\mu$m, mit einem Umformgrad größer 90 % kalt verformt, wobei die Kaltverformung mit Walzen mit definierter Oberfläche zur Einstellung von Rauigkeiten kleiner 2 $\mu$m erfolgt,

(g) die Folie wird im Anschluss an die Kaltumformung in Streifen von 5 bis 300 mm geschnitten,

(h) anschließend werden die Folienstreifen mit einem keramischen Pulver lose oder mittels eines Klebstoffs oder mittels eines in Alkohol aufgelösten Oxids beschichtet oder mit einer Trennfolie belegt und bedarfsweise getrocknet,

(i) die Folienstreifen werden danach ringförmig auf einen oder mehrere Dorne oder eine oder mehrere Hülsen aufgewickelt, wobei das innere und das äußere Ende jeweils mittels Punktschweißen oder Klammern befestigt wird,

(j) die ringförmig aufgewickelten Folienstreifen werden anschließend unter Schutzgas bei Temperaturen zwischen 600 und 1200°C für 1 min bis 300 h geglüht,

(k) wobei das geglühte folienartige Material nach dieser Glühung rekristallisiert ist und einen großen Anteil an Würfeltextur aufweist.

2. Verfahren nach Anspruch 1, **dadurch gekennzeichnet, dass** die Legierung in Mengen von mehr als einer Tonne in einem Vakuuminduktionsofen oder offen in einem Induktions- oder Lichtbogenofen, gefolgt von einer Behandlung in einer VOD oder VLF Anlage erschmolzen wird, anschließend die Legierung in Blöcken, Elektroden oder als Strangguss zur Bildung eines Vorprodukts abgegossen wird, danach das Vorprodukt zusätzlich bei Temperaturen zwischen 800 und 1350°C für 1 h bis 300 h unter Luft oder Schutzgas geglüht wird, gefolgt von einem ein- oder mehrmaligem Umschmelzen mittel VAR und/oder ESU.

3. Verfahren nach Anspruch 1 oder 2, **dadurch gekennzeichnet, dass** das Vorprodukt, das bei Temperaturen zwischen 1300 und 600°C warmgewalzt wird, wobei die Dicke des Eingangsmaterials um den Faktor 1,5 - 200 reduziert wird, so dass das Vorprodukt nach der Walzung eine Dicke von 1 bis 300mm hat und nicht rekristallisiert und/oder erholt ist und/oder (dynamisch) rekristallisiert mit einer Korngröße kleiner 300 $\mu$m, insbesondere kleiner 150$\mu$m, ist, danach zusätzlich ein 2. Mal und ggf. auch ein 3. Mal nach einer Glühung bei Temperaturen zwischen 800°C und 1350°C für 1 h bis 300h unter Luft oder Schutzgas Temperaturen zwischen 1300°C bis 600°C warmgewalzt wird, wobei die Dicke des Eingangsmaterial um den Faktor 1,5 bis 200 reduziert wird und nach der letzten Walzung eine Dicke von 1 bis 100 mm hat und nicht rekristallisiert ist oder/und erholt ist und/oder (dynamisch) rekristallisiert mit einer Korngröße kleiner 300 $\mu$m, insbesondere kleiner 150 $\mu$m, ist.

4. Verfahren nach einem oder mehreren der Ansprüche 1 bis 3, **dadurch gekennzeichnet, dass** das Vorprodukt nach den (der) Warmwalzung(en) und dem anschließend Beizen geschliffen wird.

5. Verfahren nach einem oder mehreren der Ansprüche 1 bis 4, **dadurch gekennzeichnet, dass** nach dem Beizen und/oder Schleifen, die Erzeugung einer Folie der Enddicke von 10 bis 300 $\mu$m mit einem Umformgrad größer 90 % durch Kaltverformung mit Zwischenglühungen bei Temperaturen zwischen 550°C und 1200°C und Glühzeiten für das Material zwischen 10s und 100 Stunden unter Luft oder reduzierendem Schutzgas erfolgt, wobei das Schutzgas aus Wasserstoff oder einen Wasserstoff/Stickstoffgemisch oder Argon oder einem Gemisch dieser Gase bestehen kann, gefolgt von einer Abkühlung im Ofen oder im ruhendem Schutzgas oder Luft, bewegtem (geblasenem) Schutzgas oder Luft, ggf. gefolgt von einem Beizvorgang, wobei das Material nach diesem Glühvorgang erholt ist oder/und eine Korngröße von kleiner 100$\mu$m hat.

6. Verfahren nach einem oder mehreren der Ansprüche 1 bis 5, **dadurch gekennzeichnet, dass** als keramisches Pulver ein oxidisches Pulver, insbesondere Magnesiumoxidpulver eingesetzt wird.

7. Verfahren nach einem oder mehreren der Ansprüche 1 bis 6, **dadurch gekennzeichnet, dass** als in einem Alkohol aufgelöstes Oxid Magnesiummethylat eingesetzt wird.

8. Verfahren nach einem oder mehreren der Ansprüche 1 bis 7, **dadurch gekennzeichnet, dass** der Kleber oder die Trennfolie, der/die sich auf den ringförmig auf einen oder mehrere Dorne oder eine oder mehrere Hülse aufgewickelten Folienstreifen befindet, unter einem Sauerstoff enthaltenen Gas verbrannt wird, wobei das innere und das äußere Ende der Folienstreifen jeweils mittels Punktschweißen oder Klammerung vor der Verbrennung befestigt worden ist.

9. Verfahren nach einem oder mehreren der Ansprüche 1 bis 8, **dadurch gekennzeichnet, dass** als Schutzgas für die Glühung der ringförmig aufgewickelten Folienstreifen Wasserstoff oder ein Wasserstoff/Stickstoffgemisch oder Argon oder einem Gemisch dieser Gase eingesetzt wird.

10. Verfahren nach einem oder mehreren der Ansprüche 1 bis 9, **dadurch gekennzeichnet, dass** die Glühung unter Schutzgas mit mehreren Haltezeiten von 1s bis 200 h bei verschiedenen Temperaturen zwischen 600°C und 1200°C erfolgt, wobei das spiralförmig gewickelte Band ggf. auf einen stabilisierenden Träger gelegt wird.

11. Verfahren nach einem oder mehreren der Ansprüche 1 bis 10, **dadurch gekennzeichnet, dass** nach der Glühung der ringförmig aufgewickelten Folienstreifen unter Schutzgas bei Temperaturen zwischen 600 und 1200°C die Schweißpunkte entfernt werden, die Folienstreifen danach ggf. auf eine Hülse gewickelt und die Schweißpunkte bzw. die Klammerung durch Klebestreifen ersetzt werden.

12. Verfahren nach einem oder mehreren der Ansprüche 1 bis 11, **dadurch gekennzeichnet, dass** die Warmumformung unterbrochen wird und anschließend ein Metallblechpaket durch Stapelung aus zwei oder mehreren dieser so gewalzten Produkte erzeugt wird, wobei das Blechpaket rundum verschweißt wird, danach das Blechpaket durch mechanisches Verformen wie beispielsweise Walzen warm verformt wird, wobei durch diese mechanische Verformung die Dicke des Pakets um den Faktor 1,5 bis 200 reduziert wird, mit ggf. einer oder mehreren Zwischenglühungen bei Temperaturen zwischen 800 und 1350°C für 1 h bis 300 h unter Luft oder Schutzgas, wobei ggf. die Legierungselemente der einzelnen Bleche durch eine oder mehrere Grenzflächen der Blechpakete in die Nachbarbleche diffundieren, danach das Paket an eine Enddicke von 10 bis 300 $\mu$m mit einem Umformgrad größer 90% kalt verformt wird, wobei mindestens eine der äußeren Paketschichten des Gesamtpaketes eine Textur aufweist.

13. Verfahren nach einem oder mehreren der Ansprüche 1 bis 12, **dadurch gekennzeichnet, dass** nach dem Warmumformen und Beizen und/oder nach einer Unterbrechung der Kaltumformung zwei oder mehrere Vorprodukte (warmumgeformt, kaltumgeformt oder ein Gemisch aus beiden) zu einem Paket gestapelt werden, wobei die Dicke der einzelnen Vorprodukte zwischen 100mm bis 0,08mm beträgt, die Vorprodukte ggf. vor dem Stapeln in Streifen von mindestens 10 mm geschnitten werden, die Vorprodukte ggf. entfettet werden, ggf. gefolgt von einer oder mehreren Behandlungen zur Erhöhung der Rauigkeit der Oberfläche der einzelnen Schichten wie beispielsweise Bürsten und/oder Schleifen, danach das Paket an eine Enddicke von 10 bis 300 $\mu$m mit einem Umformgrad größer 90% kalt verformt wird, wobei ggf. die Legierungselemente der einzelnen Bänder bei der (den) Glühung(en) durch eine oder mehrere Grenzflächen der Bandpakete in die Nachbarbänder diffundieren, wobei mindestens eine der äußeren Paketschichten des Gesamtpakets eine Textur aufweist.

14. Verfahren nach Anspruch 12 oder 13, **dadurch gekennzeichnet, dass** bei der Erzeugung des Paketes durch Stapelung aus zwei oder mehreren warm- oder kaltumgeformten Produkten aus Legierungen nach den Ansprüchen 15 bis 17, eine oder mehrere dieser zum Paket gestapelten Schichten durch einen metallischen Werkstoff mit einer anderen Legierungszusammensetzung ersetzt wird (werden), wobei mindestens eine der äußeren Schichten des Paketes weiterhin aus einer Legierung gemäß Anspruch 1 besteht.

15. Verfahren nach Anspruch 14, **dadurch gekennzeichnet, dass** bei der Erzeugung des Paketes durch Stapelung aus zwei oder mehreren warm- oder kaltumgeformten Produkten aus Legierungen nach den Ansprüchen 15 bis 17, eine oder mehrere dieser zum Paket gestapelten Schichten ersetzt wird (werden) durch eine Schicht aus einer Cu-Ni-Legierung mit ggf. weiteren Legierungselementen oder durch eine Schicht aus einer Ni-Cr-Legierung oder einer Ni-Cr-Fe-Legierung mit einem Ni-Gehalt von mindestens 5 % und ggf. weiteren Legierungselementen, wobei mindestens eine der äußeren Schichten des Paketes weiterhin aus einer Legierung gemäß Anspruch 1 besteht.

**Claims**

1. A method for producing a metal film from an alloy consisting of (in % by mass)

| | |
|---|---|
| W | 5 to 30 %, wherein W can be completely or partly replaced by Mo, |
| Mg | 0.0001 to 0.050 %, wherein Mg can be completely or partly replaced by Ca, if required |
| Ti | max. 0.10 % |
| Al | max. 0.10 % |
| B | max. 0.020 % |
| Fe | max. 1,0 % |
| Co | max. 1,0 % |
| Mn | max. 0.20 % |
| Si | max. 0.20 % |
| Cr, Cu, Nb | respectively max. 0.20 % |
| P | max. 0.020 % |
| C | max. 0.050 % |
| N | max. 0.020 % |
| S | max. 0.020 % |
| Ni | rest (> 50 %) |

as well as the usual impurities resulting from the smelting process comprising the following process steps:

(a) an amount of more than one ton of the alloy will be smelted in a vacuum induction furnace or openly in an induction or electric arc furnace, followed by a treatment in a VOD or VLF installation,
(b) afterwards, the alloy will be cast into ingots, electrodes or as continuous casting for forming a primary product, optionally followed by a one-time or repeated remelting by means of VAR and/or ESU
(c) afterwards, the primary product will be optionally annealed at temperatures comprised between 800 and 1350°C during a period of 1 h through 300 h in air or protective gas,
(d) then, the primary product will be hot-formed, especially hot-rolled, at temperatures comprised between 1300°C and 600°C, wherein the thickness of the original material will be reduced by the factor 1.5 - 200, such that the primary product will have a thickness comprised between 1 and 100 mm after the rolling and is not recrystallized and/or recovered and/or is (dynamically) recrystallized with a grain size of less than 300 $\mu$m, in particular less than 150 $\mu$m,
(e) the primary product will afterwards be stained and/or grinded,
(f) then, for producing a film, the primary product will be cold-formed to a final thickness comprised between 10 and 300 $\mu$m, in particular between 40 and 150 $\mu$m, with a degree of deformation of more than 90 %, wherein the cold-forming is carried out with rolls having a defined surface for setting roughnesses of less than 2 $\mu$m,
(g) after the cold-forming the film will be cut into strips of 5 to 300 mm,
(h) afterwards, the film strips will be coated with a ceramic powder in a loose manner or by means of an adhesive or by means of an oxide dissolved in alcohol or will be covered by a separating foil and optionally dried,

(i) then, the film strips will be wound up in an annular manner on one or more mandrels or one or more sleeves, wherein the inner and the outer ends will be respectively fixed by means of spot-welding or clamping,

(j) the film strips which have been wound up in an annular manner will then be annealed in protective gas at temperatures comprised between 600 and 1200°C during a period of 1 min through 300 h,

(k) wherein after this annealing the annealed film-like material will be recrystallized and comprise a high proportion of cubic texture.

2. A method according to claim 1, **characterized in that** an amount of more than one ton of the alloy will be smelted in a vacuum induction furnace or openly in an induction or electric arc furnace, followed by a treatment in a VOD or VLF installation, afterwards, the alloy will be cast into ingots, electrodes or as continuous casting for forming a primary product, then the primary product will be additionally annealed at temperatures comprised between 800 and 1350°C during a period of 1 h through 300 h in air or protective gas, followed by a one-time or repeated remelting by means of VAR and/or ESU.

3. A method according to claim 1 or 2, **characterized in that** the primary product which is hot-rolled at temperatures comprised between 1300°C and 600°C, wherein the thickness of the original material will be reduced by the factor 1.5 - 200, such that the primary product will have a thickness comprised between 1 and 300 mm after the rolling and is not recrystallized and/or recovered and/or is (dynamically) recrystallized with a grain size of less than 300 $\mu$m, in particular less than 150 $\mu$m, will afterwards be additionally hot-rolled for a second time and optionally also for a third time at temperatures comprised between 1300°C and 600°C during 1 h through 300 h in air or protective gas after an annealing at temperatures comprised between 800°C and 1350°C, wherein the thickness of the original material will be reduced by the factor 1.5 to 200 and after the last rolling operation the primary product will have a thickness comprised between 1 and 100 mm and is not recrystallized and/or recovered and/or is (dynamically) recrystallized with a grain size of less than 300 $\mu$m, in particular less than 150 $\mu$m.

4. A method according to one or more of the claims 1 through 3, **characterized in that** the primary product will be grinded after the hot-rolling operation(s) and the following staining.

5. A method according to one or more of the claims 1 through 4, **characterized in that** after the staining and/or grinding operation a foil having a final thickness comprised between 10 and 300 $\mu$m with a degree of deformation of more than 90 % will be produced by cold-forming with intermediate annealing operations at temperatures comprised between 650° and 1200°C and annealing times of the material comprised between 10s and 100 hours in air or reduced protective gas, wherein the protective gas can consist of hydrogen or a hydrogen/nitrogen mixture or argon or a mixture of these gases, followed by a cooling down in the furnace or in the inactive protective gas or air, in moving (blown) protective gas or air, optionally followed by a staining operation, wherein the material will be recovered and/or have a grain size of less than 100 $\mu$m after this annealing operation.

6. A method according to one or more of the claims 1 through 5, **characterized in that** an oxidic powder, in particular magnesium oxide powder, will be used as ceramic powder.

7. A method according to one or more of the claims 1 through 6, **characterized in that** magnesium methylate will be used as oxide dissolved in an alcohol.

8. A method according to one or more of the claims 1 through 7, **characterized in that** the adhesive or the separating foil which is placed on the film strips that are wound up in an annular manner on one or more mandrels or one or more sleeves, will be burnt in a gas containing oxygen, wherein the inner and the outer ends of the film strips have been respectively fixed before the burning operation by means of spot-welding or clamping.

9. A method according to one or more of the claims 1 through 8, **characterized in that** hydrogen or a hydrogen/nitrogen mixture or argon or a mixture of these gases will be used as protective gas for the annealing of the film strips that are wound up in an annular manner.

10. A method according to one or more of the claims 1 through 9, **characterized in that** the annealing in protective gas will be carried out with several retention times comprised between 1s and 200 h at different temperatures comprised between 600°C and 1200°C, wherein the band that has been wound helically will be optionally put on a stabilizing carrier.

11. A method according to one or more of the claims 1 through 10, **characterized in that** after the annealing of the film strips that are wound up in an annular manner in protective gas at temperatures comprised between 600 and 1200°C, the welding spots will be removed, afterwards the film strips will be optionally wound on a sleeve and the welding spots or the clamping will be replaced by adhesive strips.

12. A method according to one or more of the claims 1 through 11, **characterized in that** the hot-forming operation will be interrupted and afterwards a sheet metal packet will be produced by stacking two or more of the thus rolled products, wherein the sheet metal packet will be welded all around, then the sheet metal packet will be hot-formed by mechanical deformation such as for example rolling, wherein the thickness of the packet will be reduced by the factor 1.5 to 200 due to this mechanical deformation, with optionally one or more intermediate annealing operations at temperatures comprised between 800 and 1350°C for 1 h to 300 h in air or protective gas, wherein the alloy elements of the individual sheet metals will optionally diffuse through one or more interfaces of the sheet metal packets into the adjacent sheet metals, afterwards the packet will be cold-formed to a final thickness of 10 to 300 μm with a degree of deformation of more than 90 %, wherein at least one of the outer packet layers of the entire packet comprises a texture.

13. A method according to one or more of the claims 1 through 12, **characterized in that** after the hot-forming and staining and/or after an interruption of the cold-forming, two or more primary products (warm-formed, cold-formed or a mixture of both) will be stacked into a packet, wherein the thickness of the individual primary products is comprised between 100 mm and 0.08 mm, the primary products will be optionally cut into strips of at least 10 mm before the stacking operation, the primary products will be optionally degreased, optionally followed by one or more treatments for increasing the roughness of the surfaces of the individual layers, such as brushing and/or grinding, the packet will be afterwards cold-formed to a final thickness comprised between 10 and 300 μm with a degree of deformation of more than 90 %, wherein the alloy elements of the individual bands will optionally diffuse through one or more interfaces of the band packets into the adjacent bands during the annealing operation(s), wherein at least one of the outer packet layers of the entire packet comprises a texture.

14. A method according to claim 12 or 13, **characterized in that** during the production of the packet by means of stacking two or more hot- or cold-formed products made of alloys according to the claims 1 through 13 one or more of these layers which have been stacked into a packet will be replaced by a metal material having a different alloy composition, wherein at least one of the outer layers of the packet will continue to consist of an alloy according to claim 1.

15. A method according to claim 14, **characterized in that** during the production of the packet by means of stacking two or more hot- or cold-formed products made of alloys according to the claims 1 through 13 one or more of these layers which have been stacked into a packet will be replaced by a layer made of a Cu-Ni alloy with optionally more alloy elements or by a layer made of a Ni-Cu alloy or a Ni-Cr-Fe alloy comprising a Ni content of at least 5 % and optionally other alloy elements , wherein at least one of the outer layers of the packet will continue to consist of an alloy according to claim 1.

**Revendications**

1. Procédé de fabrication d'une feuille métallique à partir d'un alliage, qui consiste en (en % en poids)

| | |
|---|---|
| W | 5 à 30 %, W pouvant être complètement ou partiellement remplacé par Mo, |
| Mg | 0,0001 à 0,050 %, Mg pouvant être complètement ou partiellement remplacé par Ca, en cas de besoin, |
| Ti | max. 0,10 % |
| Al | max. 0,10 % |
| B | max. 0,020 % |
| Fe | max. 1,0 % |
| Co | max. 1,0 % |
| Mn | max. 0,20 % |
| Si | max. 0,20 % |
| Cr, Cu, Nb | chacun max. 0,20 % |
| P | max. 0,020 % |

(suite)

| | |
|---|---|
| C | max. 0,050 % |
| N | max. 0,020 % |
| S | max. 0,020 % |
| Ni | reste (> 50 %) |

ainsi que des impuretés usuelles résultant de l'élaboration, comprenant les étapes de procédé suivantes :

(a) une quantité de plus d'une tonne de l'alliage est élaborée dans un four à induction à vide ou ouvertement dans un four à arc électrique, suivi par un traitement dans une installation VOD ou VLF,

(b) ensuite, l'alliage est coulé dans des lingots, des électrodes ou comme coulée continue pour former un produit intermédiaire, le cas échéant, suivi par une refusion unique ou à plusieurs reprises par moyen de VAR et/ou d'ESU,

(c) ensuite, le produit intermédiaire est, en cas de besoin, recuit à des températures comprises entre 800 et 1350°C pendant 1 h à 300 h dans l'air ou dans un gaz protecteur,

(d) après, le produit intermédiaire est formé à chaud, notamment laminé à chaud, à des températures comprises entre 1300°C et 600 °C, l'épaisseur du matériau de base étant réduite par le facteur 1,5 - 200, de sorte que le produit intermédiaire comprend une épaisseur de 1 à 100 mm après le laminage et n'est pas recristallisé et/ou récupéré et/ou il est recristallisé (de manière dynamique) avec une granulométrie inférieure à 300 $\mu$m, notamment inférieure à 150 $\mu$m,

(e) le produit intermédiaire est ensuite décapé et/ou affûté,

(f) après, pour fabriquer une feuille, le produit intermédiaire est formé à froid jusqu'à obtenir une épaisseur finale comprise entre 10 et 300 $\mu$m, notamment entre 40 et 150 $\mu$m, avec un degré de déformation supérieur à 90 %, la formation à froid étant effectuée par moyen des rouleaux ayant une surface définie pour fixer des rugosités inférieures à 2 $\mu$m,

(g) après la formation à froid, la feuille est coupée dans des bandes ayant une taille de 5 à 300 mm,

(h) par la suite, les bandes de feuille sont revêtues d'une poudre céramique de manière libre ou par moyen d'un adhésif ou par moyen d'un oxyde dissous dans l'alcool ou sont recouvertes avec une feuille de séparation et, en cas de besoin, séchées,

(i) les bandes de feuille sont ensuite enroulées de manière annulaire sur un ou plusieurs mandrins ou une ou plusieurs douilles, l'extrémité intérieure et l'extrémité extérieure étant respectivement fixées par moyen de soudure par points ou de serrage,

(j) par la suite, les bandes de feuille enroulées de manière annulaire sont recuites dans un gaz protecteur à des températures comprises entre 600 et 1200°C pendant 1 min à 300 h,

(k) le matériau en forme de feuille recuit étant recristallisé après ce recuit et comprenant une grande proportion de texture cubique.

**2.** Procédé selon la revendication 1, **caractérisé en ce qu'**une quantité de plus d'une tonne de l'alliage est élaborée dans un four à induction à vide ou ouvertement dans un four à induction ou à arc électrique, suivi par un traitement dans une installation VOD ou VLF, ensuite, l'alliage est coulé dans des lingots, des électrodes ou comme coulée continue pour former un produit intermédiaire, et ensuite le produit intermédiaire est supplémentairement recuit à des températures comprises entre 800 et 1350°C pendant 1 h à 300 h dans l'air ou dans un gaz protecteur, suivi par une refusion unique ou à plusieurs reprises par moyen de VAR et/ou d'ESU.

**3.** Procédé selon la revendication 1 ou la revendication 2, **caractérisé en ce que** le produit intermédiaire est laminé à chaud à des températures comprises entre 1300 et 600°C, l'épaisseur du matériau de base étant réduite par le facteur 1,5 - 200, de sorte que le produit intermédiaire comprend une épaisseur de 1 à 100 mm après le laminage et n'est pas recristallisé et/ou récupéré et/ou il est recristallisé (de manière dynamique) avec une granulométrie inférieure à 300 $\mu$m, notamment inférieure à 150 $\mu$m, et le produit intermédiaire est ensuite supplémentairement laminé à chaud une deuxième fois et, le cas échéant, aussi une troisième fois à des températures comprises entre 1300°C et 600°C après un recuit à des températures comprises entre 800°C et 1350°C pendant 1 h à 300 h dans l'air ou dans un gaz protecteur, l'épaisseur du matériau de base étant réduite par le facteur 1,5 - 200, et après le dernier laminage le produit intermédiaire comprend une épaisseur de 1 à 100 mm et n'est pas recristallisé et/ou récupéré et/ou il est recristallisé (de manière dynamique) avec une granulométrie inférieure à 300 $\mu$m, notamment inférieure à 150 $\mu$m.

4. Procédé selon l'une ou plusieurs des revendications 1 à 3, **caractérisé en ce que** le produit intermédiaire est affûté après le(s) laminage(s) et le décapage suivant.

5. Procédé selon l'une ou plusieurs des revendications 1 à 4, **caractérisé en ce qu'**après le décapage et/ou l'affûtage, une feuille ayant une épaisseur finale comprise entre 10 et 300 $\mu$m avec un degré de déformation supérieur à 90 % est produite par formation à froid avec des recuits intermédiaires à des températures comprises entre 550°C et 1200°C et des temps de cuisson du matériau compris entre 10s et 100 heures dans l'air ou dans un gaz protecteur réduisant, le gaz protecteur pouvant consister en hydrogène ou en un mélange d'hydrogène et d'azote ou en argon ou en un mélange de ces gaz, le traitement étant suivi par un refroidissement dans le four ou dans le gaz protecteur au repos ou dans l'air au repos, dans le gaz protecteur en mouvement (soufflé) ou dans l'air en mouvement, le cas échéant, suivi par un décapage, le matériau étant récupéré et/ou ayant une granulométrie inférieure à 100 $\mu$m après ce recuit.

6. Procédé selon l'une ou plusieurs des revendications 1 à 5, **caractérisé en ce qu'**une poudre oxydique, notamment de la poudre d'oxyde de magnésium, est utilisée comme poudre céramique.

7. Procédé selon l'une ou plusieurs des revendications 1 à 6, **caractérisé en ce que** du méthylate de magnésium est utilisé comme oxyde dissous dans un alcool.

8. Procédé selon l'une ou plusieurs des revendications 1 à 7, **caractérisé en ce que** l'adhésif ou la feuille de séparation, qui se trouve sur les bandes de feuille enroulées de manière annulaire sur un ou plusieurs mandrins ou sur une ou plusieurs douilles, est brûlé(e) dans un gaz contenant de l'oxygène, l'extrémité intérieure et l'extrémité extérieure des bandes de feuille ayant été respectivement fixées par moyen de soudure par points ou de serrage avant l'incinération.

9. Procédé selon l'une ou plusieurs des revendications 1 à 8, **caractérisé en ce que** de l'hydrogène ou un mélange d'hydrogène et d'azote ou de l'argon ou un mélange de ces gaz est utilisé comme gaz protecteur pour le recuit des bandes de feuille enroulées de manière annulaire.

10. Procédé selon l'une ou plusieurs des revendications 1 à 9, **caractérisé en ce que** le recuit se fait dans un gaz protecteur avec plusieurs périodes de rétention comprises entre 1s et 200 h à des températures différentes comprises entre 600°C et 1200°C, la bande enroulée de manière hélicoïdale étant placée, le cas échéant, sur un support stabilisant.

11. Procédé selon l'une ou plusieurs des revendications 1 à 10, **caractérisé en ce qu'**après le recuit des bandes de feuille enroulées de manière annulaire dans un gaz protecteur à des températures comprises entre 600 et 1200°C, les points de soudure sont enlevés, les bandes de feuille sont ensuite, le cas échéant, enroulées sur une douille et les points de soudure ou le serrage sont remplacés par des bandes adhésives.

12. Procédé selon l'une ou plusieurs des revendications 1 à 11, **caractérisé en ce que** la formation à chaud est interrompue et ensuite un paquet de tôles métalliques est formé en empilant deux ou plusieurs de ces produits laminés, le paquet de tôles étant soudé tout autour, le paquet de tôles est ensuite formé à chaud par déformation mécanique, telle que par exemple du laminage, l'épaisseur du paquet étant réduite par le facteur 1,5 à 200 grâce à cette déformation mécanique avec, le cas échéant, un ou plusieurs recuits intermédiaires à des températures comprises entre 800 et 1350°C pendant 1 h à 300 h dans l'air ou dans un gaz protecteur, les éléments d'alliage des tôles individuelles diffusant, le cas échéant, à travers une ou plusieurs interfaces des paquets de tôles dans les tôles adjacentes, le paquet étant ensuite formé à froid jusqu'à obtenir une épaisseur finale comprise entre 10 et 300 $\mu$m avec un degré de déformation supérieur à 90 %, au moins une des couches de paquet extérieures du paquet entier comprenant une texture.

13. Procédé selon l'une ou plusieurs des revendications 1 à 12, **caractérisé en ce qu'**après la formation à chaud et le décapage et/ou après une interruption de la formation à froid deux ou plusieurs produits intermédiaires (formés à chaud, formés à froid ou un mélange des deux) sont empilés dans un paquet, l'épaisseur des produits intermédiaires individuels étant comprise entre 100 mm et 0,08 mm, les produits intermédiaires sont, le cas échéant, coupés dans des bandes d'au moins 10 mm avant l'empilage, les produits intermédiaires sont, le cas échéant, dégraissés, ce traitement étant facultativement suivi par un ou plusieurs traitements, tel que le brossage et/ou l'affûtage, pour augmenter la rugosité de la surface des couches individuelles, le paquet est formé à froid pour obtenir une épaisseur finale comprise entre 10 et 300 $\mu$m avec un degré de déformation supérieur à 90 %, les éléments d'alliage des bandes individuelles diffusant, le cas échéant, à travers une ou plusieurs interfaces des paquets de bandes dans les bandes adjacentes pendant le(s) recuit(s), au moins une des couches de paquet extérieures du paquet entier comprenant une texture.

14. Procédé selon la revendication 12 ou la revendication 13, **caractérisé en ce que** pendant la formation du paquet par moyen d'empilage de deux ou de plusieurs produits formés à chaud ou formés à froid et consistant en des alliages selon les revendications 1 à 13, une ou plusieurs de ces couches empilées dans un paquet est (sont) remplacée(s) par un matériau métallique ayant une autre composition d'alliage, au moins une des couches extérieures du paquet continuant à consister en un alliage selon la revendication 1.

15. Procédé selon la revendication 14, **caractérisé en ce que** pendant la formation du paquet par moyen d'empilage de deux ou de plusieurs produits formés à chaud ou formés à froid et consistant en des alliages selon les revendications 1 à 13, une ou plusieurs de ces couches empilées dans un paquet est (sont) remplacée(s) par une couche en un alliage Cu-Ni comprenant, le cas échéant, d'autres éléments d'alliage ou par une couche en un alliage Ni-Cr ou en un alliage Ni-Cr-Fe comprenant une teneur en Ni d'au moins 5 % et, le cas échéant, d'autres éléments d'alliage, au moins une des couches extérieures du paquet continuant à consister en un alliage selon la revendication 1.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69706083 T2
- DE 102008016222 A1
- DE 2816173
- DE 102004060900
- DE 102005013368
- WO 2012136181 A

**In der Beschreibung aufgeführte Nicht-Patentliteratur**

- **V. SUBRAMANYA et al.** *Scripta Materialia,* 2004, vol. 50, 953-957